# EUROPEAN PATENT APPLICATION

(11) **EP 0 930 508 A1**
(43) Date of publication of application: **21.07.1999**
(21) Application number: 98933927.0
(22) Date of filing: 24.07.1998
(51) Int. Cl.: G01R 33/02, H01L 43/00, G11B 5/33

(54) **MAGNETIC IMPEDANCE EFFECT DEVICE**

(30) Priority: 29.07.1997 JP 20289697; 29.07.1997 JP 20289897; 28.11.1997 JP 32841297
(71) Applicant: UNITIKA LTD., Amagasaki-shi, Hyogo 660-0824 (JP)
(72) Inventor: KAWASHIMA, Katsuhiro, Uji, Uji-shi, Kyoto 611-0021 (JP); UENO, Shuji, 13-403, Kangetsukyodanchi, Fushimi-ku, Kyoto-shi, Kyoto 612-8034 (JP); FURUKAWA, Shinji, Fushimi-ku, Kyoto-shi, Kyoto 612-8122 (JP)
(74) Representative: VOSSIUS & PARTNER
(86) International application number: JP9803315
(87) International publication number: WO9906848

(57) **Abstract**

Magneto-impedance effect device has a magnetic material 13 that has magneto-impedance effect on one principal surface of a board 12 made of a electrically insulating material and has a conductor pattern 34 for applying a bias magnetic field to the magnetic material 13 on the other principal surface of the board 12 oppositely to the magnetic material 13 with the board 12 interposed between them. The magnetic material 13 is arranged on the board 12 approximately perpendicularly to the direction of a current that flows through the conductor pattern 34. To the magnetic material 13 is applied an AC voltage, and the change in impedance of the magnetic material 13 due to an external magnetic field Hb is taken out of both ends of the magnetic material 13. The obtained device has a simple structure to make manufacturing processes easy, has good characteristics of detecting the magnitude and direction of the magnetic field and has a small thickness dimension.

## Description

### TECHNICAL FIELD

The present invention relates to a magneto-impedance effect device for detecting very weak magnetic field, and in particular, to magneto-impedance effect device for use in a magnetic head or the like for detecting magnetic field to be mounted in magnetic recording apparatuses such as tape recorders, magnetic storage apparatuses for computers, a variety of measurement control apparatuses and the like.

### BACKGROUND ART

In general, as a device for detecting magnetic field, there has previously been known an induction coil type magnetic reading head (inductive head) for guiding a magnetic flux into a core around which a coil is wound and for outputting an induced voltage proportional to a change in time of the magnetic flux that links the coil. In contrast to this, in recent years, there has been a trend that a magneto-resistance (MR) effect device whose electric resistance is varied by a magnetic field is adopted in various sorts of electronic equipments including magnetic storage apparatuses for personal computers, because the device can cope with the increase in density and in capacity of magnetic recording. In particular, a device called the giant magneto-resistance (GMR) device is attracting considerable attention, since it has a ratio of change in electric resistance of about ten and several percent in a magnetic field of 20 Oersteds (Oe), which is several times greater than that of the conventional magneto-resistance effect device.

On the other hand, besides the above-mentioned magneto-resistance effect device whose electric resistance is varied by the magnetic field, a magneto-impedance effect device utilizing magneto-impedance effect (MI) that the impedance is varied by a magnetic field has also been known (refer to, for example, Japanese Patent laid-open Publications Nos. 6-283344/1994 and 8-75835/1996).

For example, Japanese Patent laid-open Publication No. 6-283344/1994 discloses an element provided with a magnetic material of a circular cross section having a high magnetic permeability in the circumferential direction. If an AC current is applied across both ends of this magnetic material, a voltage in accordance with the change in time of the magnetic flux in the circumferential direction and a voltage of the product of the electric resistance of the magnetic material and the current are induced across both ends of the magnetic material. Then, in an excitation frequency region where the frequency of AC current used for the excitation of the magnetic material is low enough to ignore the skin effect of the magnetic material, the voltage in accordance with the change in time of the magnetic flux in the circumferential direction is varied mainly by an external magnetic field. The voltage in accordance with the change in time of the magnetic flux in the circumferential direction, i.e., a change in inductance in this case can be detected by a bridge circuit with high accuracy, and the external magnetic field can be detected on the basis of this change in inductance. Because this kind of device detects the external magnetic field on the basis of the change in inductance, it is called the magneto-inductance (MI) effect device.

In contrast to this, if an AC current flows through a magnetic material in a high-frequency region in which the skin effect appears, the amplitude of the voltage across both ends of the magnetic material shows a change of 40 to 50 percent due to an externally applied magnetic field. In this case, the magneto-inductance effect device is often called the magneto-impedance (MI) effect device. The magneto-impedance effect device is considered to include the magneto-inductance effect device in a broad sense, and also in this description, it is assumed that the concept represented by the magneto-impedance effect device includes the magneto-inductance effect device.

As described above, the magneto-impedance effect device can detect the external magnetic field as a change in inductance or impedance. Then, if such a magneto-impedance effect device is employed, a magnetic sensing device can have a sensitivity higher than that of the giant magneto-resistance device, for example, a ratio of change of 50 percent in an external magnetic field of two Oersteds or a ratio of change of about 80 percent in an external magnetic field of five Oersteds. In addition, a magnetic device having a high response speed and a low consumption of power can be constructed.

The magneto-impedance effect device also has an advantage that a compact device having a simple construction can be provided because it is not needed to arrange a coil around the magnetic core, differently from the inductive head. Furthermore, as disclosed in Japanese Patent laid-open Publication No. 8-75835/1996, a more compact magneto-impedance effect device having a small thickness can be provided with a magnetic material that employs a magnetic thin film having magneto-impedance effect. As described above, the above-mentioned prior art magneto-impedance effect device is compact and further has the advantage that a detection sensitivity higher than that of the giant magneto-resistance effect device can be obtained with a simple construction that necessitates no coil.

The magnetic field is a vector quantity having a magnitude and a direction. In contrast, the above-mentioned prior art magneto-impedance effect device theoretically varies its output voltage relative to a change in magnetic field, that is, a scalar quantity. Therefore, the above-mentioned device has a problem that it can detect the magnitude of the magnetic field but cannot detect the direction thereof.

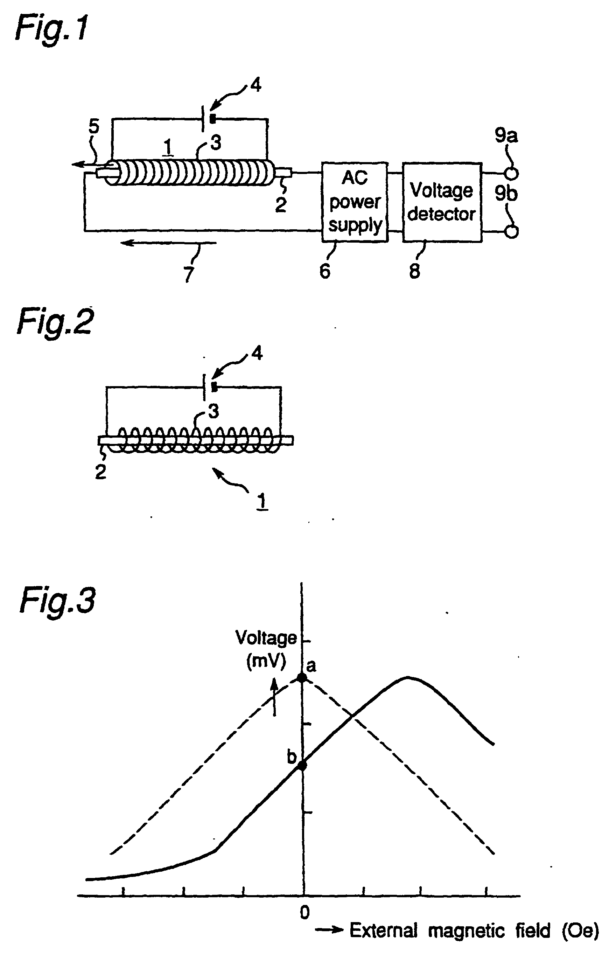

On the other hand, Japanese Patent laid-open Publication No. 9-133742/1995 proposes a magneto-impedance effect device that can detect the magnitude and direction of the magnetic field. This kind of magneto-impedance effect device, the construction of which is exemplified in, for example, Figs. 1 and 2, is constructed of a magnetic material 2 that shows magneto-impedance effect and a solenoid-type winding coil 3. The magnetic material 2 is inserted in the coil 3 in the magneto-impedance effect device 1. DC current is applied to the winding coil 3 from a DC power source 4 so as to apply a DC magnetic field as a bias magnetic field 5 in a specified direction to the magnetic material 2, while an AC current flows through the magnetic material 2 an AC power supply 6 through electrodes provided at both ends of the magnetic material 2. A change in voltage across the two electrodes due to an external magnetic field 7 is detected by a voltage detecting means 8 and is taken out of output terminals 9a and 9b.

The bias magnetic field 5 is applied to the magnetic material 1 in order to detect the direction of the external magnetic field 7. As shown in Fig. 3, when the bias magnetic field 5 is not applied, the voltage change occurring across both ends of the magnetic material 2 becomes symmetrical about a point "a" as indicated by a dashed line since the voltage change depends on the intensity of the external magnetic field and does not depend on the polarity (positive or negative) of the magnetic field. Therefore, the direction of the magnetic field cannot be immediately specified by the voltage value. That is, the direction of the external magnetic field cannot be detected. In contrast to this, if the bias magnetic field 5 is applied to the magnetic material 1, then the change in voltage across both ends of the magnetic material 2 relative to the external magnetic field is shifted in the positive direction of the horizontal axis as indicated by, for example, a solid line in Fig. 3 as compared with a dashed line. With this shift, the voltage changes linearly in the vicinity of a point "b" at which the external magnetic field becomes zero, and the magnitude and polarity of the external magnetic field can be uniquely determined in this region by the output voltage from the magnetic material 2.

As described above, according to the prior art magneto-impedance effect device 8, if the bias magnetic field 5 is applied to the magnetic material 2 by the coil 3 wound around the magnetic material 1, then the direction of the magnetic field can be detected together with the magnitude thereof, so that the magnetic field detection sensitivity is also improved.

However, the prior art magneto-impedance effect device has had a problem that the shapes and constructions of the magnetic material 1 and the coil 3 are limited by the mutual arrangement of both of them since the coil 3 is necessitated for applying the bias magnetic field 5 to the magnetic material 1. Furthermore, processes for manufacturing the device must include a process of inserting the magnetic material 2 into the winding coil 3 or a process of winding the coil 3 around the magnetic material 2, and this leads to a problem that the manufacturing processes of the device is very complicated.

### DISCLOSURE OF THE INVENTION

A principal object of the present invention is to provide a compact magneto-impedance effect device that has a small thickness dimension and a simple structure and can detect the magnitude and direction of a magnetic field by using a conductor pattern located within a plane as a bias magnetic field generating means.

Another object of the present invention is to provide a magneto-impedance effect device that is able to control the magnitude of a bias magnetic field applied to the magnetic material and to simply cope with the specifications of a magnetic sensor to be used for a variety of applications.

Yet another object of the present invention is to provide a magneto-impedance effect device that has linearity of detecting the magnitude and direction of a magnetic field and is excellent in signal-to-noise ratio.

In order to achieve the above-mentioned objects, the magneto-impedance effect device of the present invention is characterized in that a synthetic magnetic field generated around a current flowing through a planar conductor pattern is used as the bias magnetic field generating means. That is, the magneto-impedance effect device of the present invention is constructed of a magnetic material having a magneto-impedance effect and a bias magnetic field generating means for providing a bias magnetic field for the magnetic material. The bias magnetic field generating means includes one that employs a conductor pattern located within a plane and one that employs a planar coil element. A variety of combinations of the magnetic material and the coil element can be achieved. For example, there are a combination of one magnetic material and a plurality of planar coil elements and another combination of two magnetic materials and one or more planar coil elements. The magnetic material and the bias magnetic field generating means can be mounted on one or two substrates.

A first magneto-impedance effect device according to the present invention comprises at least one magnetic material having magneto-impedance effect and a conductor pattern located within a plane, for applying a magnetic field generated by a current flowing through the conductor pattern.

A second magneto-impedance effect device according to the present invention is based on the first magneto-impedance effect device and comprises a magnetic material having magneto-impedance effect and a bias magnetic field generating means, comprised of a conductor pattern located within a plane, for applying a magnetic field generated by a current flowing through the conductor pattern as a bias magnetic field to the magnetic material, wherein the conductor pattern is comprised of a plurality of belt-shaped patterns that have a dimension in a direction in which the current flows, the dimension being greater than that of the magnetic material in a direction perpendicular to the direction in which the magnetic material extends. When a current that changes with time flows through the magnetic material, the impedance of the magnetic material varies according to the magnitude and direction of an external magnetic field. This change in impedance is taken out of the magnetic material as a signal. The bias magnetic field generating means for applying the bias magnetic field to the magnetic material is comprised of a conductor pattern located within a plane, having a simple construction, and this obviates the need for the complicated process of winding the coil around the magnetic material. Furthermore, the conductor through which the current for generating the bias magnetic field is located substantially within the plane, and therefore, the total thickness of the magneto-impedance effect device is reduced.

Furthermore, if the magnetic material is supported on one principal surface of the support board made of an electrically insulating material, then the magnetic material is supported on the support board, and the magnetic material and the conductor pattern are electrically insulated and supported. Therefore, a distance between the magnetic material and the bias magnetic field generating means is correctly defined by the thickness of the board.

The magnetic material should preferably be arranged approximately perpendicularly to the direction of the current flowing through the conductor pattern. The bias magnetic field generated by the current flowing through the planar conductor pattern becomes approximately constant throughout the whole portion of the magnetic material, so that a uniform bias magnetic field is applied to the whole portion of the magnetic material. With this arrangement, the magneto-impedance effect device has excellent reproducibility in the characteristic. Equal currents flow through the plurality of belt-shaped conductor patterns. The magnetic material should preferably be arranged approximately perpendicularly to the direction of the current flowing through the conductor patterns. With this arrangement, the local magnetic fields generated by the currents flowing through the belt-shaped conductor patterns become equal to one another and the synthetic magnetic field becomes more uniform in each portion, so that the more uniform bias magnetic field is applied to the whole portion of the magnetic material.

A third magneto-impedance effect device according to the present invention is based on the first magneto-impedance effect device, and it comprises a magnetic material having magneto-impedance effect and planar coil elements arranged in an identical direction approximately parallel to the magnetic material. These coil elements are connected to each other by a connecting member so that magnetic fields generated by the currents flowing through the coil elements become reverse to each other, and there is provided a bias magnetic field generating means for applying a synthetic magnetic field of the magnetic fields generated by the currents flowing through the coil elements as a bias magnetic field to the magnetic material. When a current that changes with time flows through the magnetic material, the impedance varies according to the magnitude and direction of the external magnetic field. This change in impedance is taken out of the magnetic material as a signal. The bias magnetic field generating means for applying the bias magnetic field to the magnetic material has a simple construction comprised of a planar coil element, and this obviates the need for the complicated process of winding the coil around the magnetic material and reduces the total thickness of the magneto-impedance effect device.

Furthermore, preferably, in the above-mentioned third magneto-impedance effect device, the planar coil is a spiral coil, the connecting member electrically connects the end portions of adjacent spiral coils to each other, and the magnetic material is arranged along the connecting member. By controlling the current flowing through the spiral coils, the magnitude of the bias magnetic field applied to the magnetic material is controlled. With this arrangement, the operating point of the magneto-impedance effect device can also be easily adjusted.

Furthermore, preferably, in the above-mentioned third magneto-impedance effect device, the magnetic material is arranged in one principal surface of one support board, the planar coil is arranged on a coil board, and the support board is arranged on the coil board with the other principal surface facing the planar coil. By replacing the coil board with one having different spiral coil specifications, the range of adjustment of the bias magnetic field applied to the magnetic material can be changed in various ways.

Furthermore, preferably, in the above-mentioned third magneto-impedance effect device, the magnetic material and the bias magnetic field generating means are supported on one principal surface of the support board while being electrically insulated. In regard to the magnetic material, the distance between the magnetic material and the bias magnetic field generating means is correctly defined by the thickness of the electrically insulating layer.

Furthermore, preferably, in the above-mentioned magneto-impedance effect devices, the connecting member has a conductor pattern whose dimension in a direction in which the current flows is greater than that of the magnetic material in a direction perpendicular to the direction in which the magnetic material extends. In regard to the conductor pattern, there may be a plurality of belt-shaped conductor patterns.

Furthermore, preferably, in the above-mentioned second magneto-impedance effect device, the bias magnetic field generating means is comprised of flat solenoid coils whose conducting wires are wound in reverse directions to each other, and the flat solenoid coils are connected to each other so that the directions of magnetic fields generated by the coils are reverse to each other. By adjusting the currents flowing through the flat coils and the positions, the magnitude and distribution of the bias magnetic field applied to the magnetic material are controlled, so that the operating point of the magneto-impedance effect device can be adjusted in a wide range. Furthermore, the board for supporting the flat solenoid coils is not necessary.

A fourth magneto-impedance effect device according to the present invention is based on the above-mentioned third magneto-impedance effect device and comprises at least two magnetic materials having magneto-impedance effect and a bias magnetic field generating means provided with a planar coil element arranged in an identical plane roughly parallel to the magnetic material, the at least two magnetic materials being arranged in positions with interposition of the planar coil element. A bias magnetic field is generated by the current flowing through the coil element and applied to the magnetic material.

In this case, one end portion of the magnetic material is located in a position of radius which connects the center of the planar coil to the peripheral portion of the coil, and at least two magnetic materials are arranged in a relatively identical plane with interposition of the planar coil. It is to be noted that the term of "center" means the center in the plane for converging and diverging the magnetic flux (magnetic field) in the planar coil. In this case, when a current that changes with time flows through the magnetic material, the impedance of the magnetic material varies according to the magnitude and direction of the external magnetic field. To the at least two magnetic materials arranged above and below the planar coil are applied bias magnetic fields of different directions. Therefore, the changes in impedance of them are biased positively or negatively with respect to the external magnetic field. If the electric signals from these magnetic materials are converted by a differential amplifier, then the relation between the external magnetic field and the output voltage comes to have a linear characteristic that passes through the origin. Thus, this magneto-impedance effect device has a linear characteristic capable of detecting the magnitude and direction of the magnetic field and is excellent in signal-to-noise ratio. The bias magnetic field generating means for applying the bias magnetic field to the magnetic material has a simple construction comprised of the planar coil element. The use of the planar coil obviates the need for the process of winding the coil around the magnetic material and reduces the total thickness of the magneto-impedance effect device. By means of a laminate structure or the like, the magnetic material can be supported easily and securely, and the distance between the magnetic material and the bias magnetic field generating means can be correctly defined, so that the characteristic change is little. In regard to the bias generating means, the magnitude of the bias magnetic field applied to the magnetic material can be easily controlled, so that a uniform bias magnetic field can be applied to the whole portion of the magnetic material.

Preferably, in this magneto-impedance effect device, the planar coil element is comprised of at least two spiral coils, the connecting member electrically connects the end portions of the at least two spiral coils so that the magnetic fields generated by currents flowing through the spiral coils are reverse to each other, and the magnetic material is arranged along tie connecting member. The currents are supplied to the spiral coils, and the synthetic magnetic field of the magnetic fields generated by the spiral coils is applied as a bias magnetic field to the magnetic material. By controlling the current flowing through the spiral coils, the magnitude of the bias magnetic field applied to the magnetic material is controlled. By this procedure, an operating point of the magneto-impedance effect device can also be adjusted easily.

### BRIEF DESCRIPTION OF DRAWINGS

Fig. 1 is a schematic view of a prior art magneto-impedance effect device and its detection circuit system;
Fig. 2 is a diagram of the magneto-impedance effect device of Fig. 1;
Fig. 3 is a graph of magnetic field detection characteristics when a bias magnetic field is applied to the magneto-impedance effect device of Fig. 1 and when the bias magnetic field is zero;
Fig. 4 is a plan view of magneto-impedance effect device according to a first embodiment of the present invention;
Fig. 5 is a bottom view of the magneto-impedance effect device of Fig. 4;
Fig. 6 is a sectional view taken along the line A-A' in Figs. 4 and 5;
Fig. 7 is a bottom view of another conductor pattern of the magneto-impedance effect device according to the first embodiment of the present invention;
Fig. 8 is a block circuit diagram showing a construction for detecting an external magnetic field by magneto-impedance effect device according to the present invention;
Fig. 9 is a graph of magnetic field detection characteristics of the magneto-impedance effect device of Fig. 4 when a bias magnetic field is superimposed and when the bias magnetic field is zero;
Fig. 10 is a bottom view of magneto-impedance effect device according to a second embodiment of the present invention;
Fig. 11 is a sectional view taken along the line A-A' in Fig. 10;
Fig. 12 is a plan view of a coil board of magneto-impedance effect device according to a third embodiment of the present invention;
Fig. 13 is a sectional view of the magneto-impedance effect device taken along the line B-B' of the coil board of Fig. 12;
Fig. 14 is a sectional view of a coil board of magneto-impedance effect device according to a fourth embodiment of the present invention;
Fig. 15 is a graph of magnetic field detection characteristics of the magneto-impedance effect device of Fig. 10 when a bias magnetic field is superimposed and when the bias magnetic field is zero;
Fig. 16 is a plan view of magneto-impedance effect device according to a fifth embodiment of the present invention;
Fig. 17 is a bottom view of the magneto-impedance effect device of Fig. 16;
Fig. 18 is a sectional view taken along the line A-A' in Fig. 16 and Fig. 17;
Fig. 19 is a plan view of a coil board of magneto-impedance effect device according to a sixth embodiment of the present invention;
Fig. 20 is a sectional view of the magneto-impedance effect device taken along the line B-B' of the coil board of Fig. 19;
Fig. 21 is a block circuit diagram showing a construction for detecting an external magnetic field by magneto-impedance effect device according to the present invention;
Fig. 22 is a graph of magnetic field detection characteristics at points 63a and 63b of the magneto-impedance effect device of Fig. 16 when a bias magnetic field is superimposed and when the bias magnetic field is zero; and
Fig. 23 is a graph of magnetic field detection characteristics of a circuit output 64 of the magneto-impedance effect device of Fig. 16 when the bias magnetic field is superimposed and when the bias magnetic field is zero.

### BEST MODE FOR CARRYING OUT THE INVENTION

Embodiments of the magneto-impedance effect device according to the present invention will be described below with reference to the drawings. In the drawings, same reference numerals denote same or similar components.

### (First Embodiment)

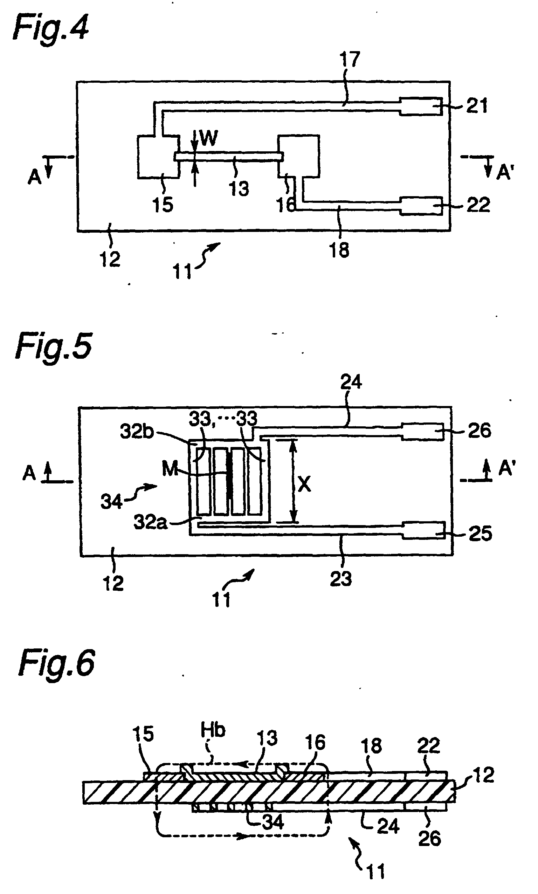

Figs. 4 to 6 show a magneto-impedance effect device 11 according to a first embodiment of the present invention. The magneto-impedance effect device 11 has a construction in which an elongated magnetic material 13 having magneto-impedance effect is arranged on one principal surface of a rectangular support board 12 made of an electrically insulating material such as glass or glass epoxy resin as shown in Fig. 4, and a rectangular planar conductor pattern 34 for applying a bias magnetic field to the magnetic material 13 is arranged on the other principal surface of a support board 12 oppositely to the magnetic material 13 with interposition of the support board 12 as shown in Fig. 5. The magnetic material 13 is arranged on the one principal surface of the support board 12 approximately perpendicularly to the direction (indicated by the arrow M in Fig. 5) of a current flowing through the planar conductor pattern 34. The planar conductor pattern 34 has its dimension X in a direction in which the current flows, the dimension X being greater than a dimension W of the magnetic material 13 in a direction perpendicular to the direction in which the magnetic material 13 extends.

Any material may be used for the magnetic material 13 regardless of its crystal structure (crystal, amorphous), alloy composition and shape (wire, ribbon, thin film) so long as the material shows magneto-impedance effect. A soft magnetic material having a magnetic permeability of not smaller than 1,000 in an excitation magnetic field of 5 milliOersteds at 1 kHz, which shows remarkable magneto-impedance effect, can therefore be appropriately employed. Co-Fe-Si-B amorphous metal material can be appropriately employed as the material of the magnetic material 13, and it can be easily obtained as a material having magnetic permeability of not smaller than 1,000 in excitation magnetic field of 5 milliOersteds at 1 kHz in any of the shapes of wire, ribbon and thin film. Among others, the amorphous metal wire and ribbon are particularly preferably as a material that shows excellent magneto-impedance effect.

The magnetic material 13 has its both ends electrically connected to connection electrodes 15 and 16 formed on the one principal surface of the support board 12. These connection electrodes 15 and 16 are led to terminal electrodes 21 and 22, respectively, formed in the vicinity of one side of the one principal surface of the support board 12 by way of connection patterns 17 and 18. An AC voltage is applied across the terminal electrodes 21 and 22. The planar conductor pattern 34 is also led to current supply terminals 25 and 26, respectively, formed in the vicinity of one side of the other principal surface of the support board 12 by way of connection patterns 23 and 24. DC current is applied across these current supply terminals 25 and 26.

The planar conductor pattern 34 is constructed by interposing a plurality of belt-shaped conductor patterns 33, ..., 33 that have a specified width and are arranged at regular intervals between two connection electrodes 32a and 32b. These belt-shaped conductor patterns 33, ..., 33 are connected to the current supply terminals 25 and 26, respectively, by way of the connection patterns 23 and 24 connected to the connection electrodes 32a and 32b, respectively. The magnetic material 13 (see Fig. 5) is arranged on the one principal surface of the support board 12 approximately perpendicularly to the direction of the belt-shaped conductor patterns 33, ..., 33. A sufficient bias characteristic can be obtained by forming a current of about 0.01 to 1 ampere in a case where each of the belt-shaped conductor patterns 33, ..., 33 has, for example, width of 0.2 mm, thickness of 0.03 mm and the support board 12 has thickness (equal to a distance to the magnetic material 13 in Fig. 4) of 0.03 to 0.8 mm.

According to the present embodiment, equal currents flow through the belt-shaped conductor patterns 33, ..., 33. Therefore, a synthetic magnetic field of the magnetic fields formed by the belt-shaped conductor patterns 33 becomes uniform in each portion of the magnetic material 13, to generate uniform bias magnetic field Hb. The structure for generating the bias magnetic field Hb is relatively simple, so that the bias magnetic field Hb can be efficiently applied to the magnetic material 13 by a very small current. If the DC current is supplied from the current supply terminals 25 and 26 through the connection patterns 23 and 24, the bias magnetic field Hb along the magnetic material 13 is generated as indicated by a dashed line in Fig. 6. Then, the dimension X of the planar conductor pattern 34 in the direction in which the currents flow becomes greater than the dimension W of the magnetic material 13 in the direction perpendicular to the direction in which the magnetic material 13 extends as described above. Therefore, the bias magnetic field Hb is uniformly distributed to each portion of the magnetic material 13. With this arrangement, each portion of the magnetic material 13 is magnetically uniformly biased, so that the magnitude and direction (polarity) of an external magnetic field can be detected by the value of a voltage outputted from both ends of the magnetic material 13 in a region where the external magnetic field becomes zero as described with reference to Fig. 3. As described above, according to the present embodiment, the structure for generating the bias magnetic field Hb is simple, and the bias magnetic field Hb can be efficiently applied to the magnetic material 13 even with a very small current.

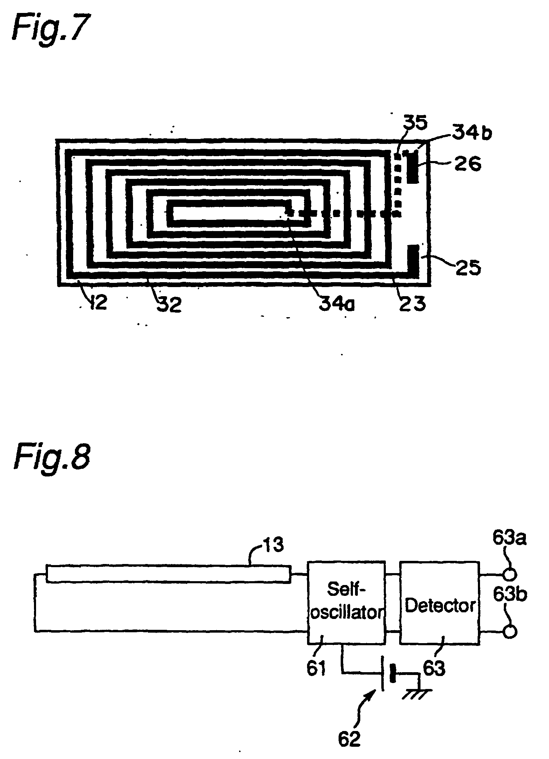

Fig. 7 shows a modified example of a conductor pattern 32 formed in a planar coil shape for generating a bias magnetic field formed in place of the planar conductor pattern 34 shown in Fig. 6. In regard to this planar coil pattern 32, an inner end terminal of the planar coil pattern 32 is connected to the terminal 26 by way of a throughhole 34a formed in its center portion and a connection conductor pattern 35 (intermittently illustrated in the drawing) that is formed on the opposite principal surface and connects the terminals to each other. An outer end terminal of the planar coil pattern 32 is connected to the current supply terminal 25 by way of the connection pattern 23. A plurality of planar coil patterns 32 are provided between the center of the coil and the peripheral portion, and a sufficient bias can be obtained by forming a current of about 0.01 to 1 ampere.

In regard to the DC current for generating the bias magnetic field Hb, DC current flowing through the conductor portion formed within one plane or a metal portion on a plane can be used generally, aside from the planar conductor patterns 34 and 32 formed on the support board 12 as shown in Figs. 5 and 7. In detecting the external magnetic field, the current is properly used by varying the magnitude of the current, the distance between the magnetic material and the current and the material, size and so on of the conductor portion as required.

### (First Example)

First Example of the magneto-impedance effect devise described above will be described next. With an amorphous magnetic wire used as the magnetic material 13 that showed magneto-impedance effect, the magneto-impedance effect device 11 described with reference to Figs. 4 to 6 was produced. For the magnetic material 13, an amorphous magnetic wire that had a composition of (Co₀.₃₄Fe₀.₀₆)₇₂.₅Si₁₂.₅B₁₅ and a diameter of 30 µm was obtained from a quenched material through a cold drawing process and was further heat treated at a temperature of 475°C. For the support board 12, a glass fabric epoxy board (FR-4: NEMA (National Electrical Manufacturers Association)) having a size of thickness of 0.6 mm, width of 4.0 mm and length of 9 mm was used. The area of the connection electrodes 15 and 16 connected to the magnetic material 13 was 1 mm square, and the electrode distance was 5 mm.

As a means for applying the bias magnetic field Hb, the conductor pattern 34 of Fig. 5 was formed on the support board 12. Further, magneto-impedance effect device that had quite the same construction except for the use of the planar spiral coil pattern 32 shown in Fig. 7 was also produced. In former case, the above-mentioned planar conductor pattern 34 is obtained by connecting eight belt-shaped conductor patterns 33, ..., 33, each of which has line width of 0.2 mm and thickness of 0.03 mm. In the latter case, the planar spiral coil pattern 32 is obtained by providing parallel belt-shaped conductor patterns 33, ..., 33, each of which has width of 0.2 mm and thickness of 0.03 mm.

Next, the magnetic field detection characteristic of these magneto-impedance effect devices 11 was measured with the circuit shown in Fig. 8. A self-oscillation circuit 61 is operated on a DC power source 62 and is used to flow a high-frequency current at 20 MHz through the magnetic material 13. A detection circuit 63 outputs a change in impedance of the magnetic material 13 as a change of an electric signal from output terminals 63a and 63b. The magneto-impedance effect device 11 connected to the self-oscillation circuit 61 was placed in a solenoid coil that had inner diameter of 100 mm, winding length of 300 mm and the number of turns of 560, placed in an external magnetic field that varies with a triangular waveform of amplitude of 5 Oersteds and frequency of 300 Hz. Then, the magnetic field detection characteristic was measured.

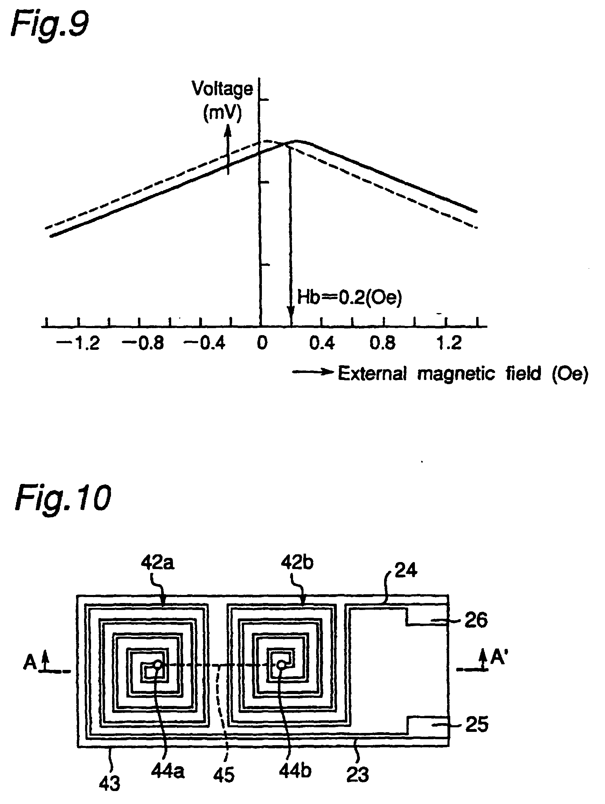

Fig. 9 shows the thus-obtained characteristic of the magneto-impedance effect device 11. In Fig. 9, the abscissa represents the external magnetic field exerted on the magneto-impedance effect device 11, while the ordinate represents the voltage obtained from the magneto-impedance effect device 11. A dashed line in Fig. 9 represents the characteristic in a case where a current is not flown through the conductor pattern 34, while a solid line represents the characteristic in a case where DC current of 0.3 ampere is flown through the planar conductor pattern 34.

As shown in Fig. 9, by generating the bias magnetic field Hb by a current flowing through the planar conductor pattern 34, an operating point for the magneto-impedance effect is shifted in the positive direction of the horizontal axis. The magnitude of the bias magnetic field Hb was 0.2 Oersted. When the direction of the current flowing through the planar conductor pattern 34 is reversed with same magnitude, then the apex of the curve of the detection characteristic was located at -0.2 Oersted contrary to Fig. 9. According to the results, it was confirmed that the magnitude and polarity (direction) of the external magnetic field could be detected by the magneto-impedance effect device 11 of the First Example.

Similarly, in the other sample mentioned above according to the construction shown in Fig. 7, it was discovered that the bias magnetic field Hb of 0.2 Oersted was applied to the magnetic material 13 by DC current of 0.3 ampere across the current supply terminals 25 and 26. Then, it was confirmed that the magnitude and polarity (direction) of the magnetic field could be detected by the magneto-impedance effect device 31 of the Second Example, similarly to the First Example.

In following second to fourth embodiments, magneto-impedance effect devices employ various bias magnetic field generating means instead of the planar conductor patterns 34 and 32.

### (Second Embodiment)

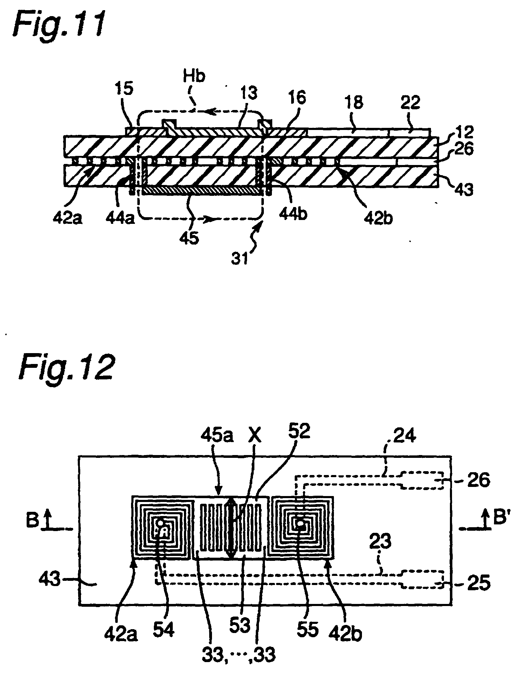

Magneto-impedance effect device 11 according to a second embodiment of the present invention will be described next. In the magneto-impedance effect device 11, a magnetic material 13 is arranged on the upper surface of a support board 12, as shown in Fig. 4, similarly to the first embodiment, while the lower surface of the support board and a coil board 43 have a structure as shown in Figs. 10 and 11.

As already described above with reference to Fig. 4, the magnetic material 13 having magneto-impedance effect is arranged on one principal surface of the rectangular support board 12 made of an electrically insulating material such as glass or glass epoxy resin. The magnetic material 13 has its both ends electrically connected to connection electrodes 15 and 16 formed on the one principal surface of the support board 12. The connection electrodes 15 and 16 are led to terminal electrodes 21 and 22, respectively, formed in the vicinity of one side of the one principal surface of the support board 12 by way of connection patterns 17 and 18. An AC voltage is applied across these terminal electrodes 21 and 22. Further, as shown in Figs. 10 and 11, on the other principal surface of the support board 12 faces to the coil board 43 on which spiral planar coil patterns (spiral coils) 42a and 42b for applying a bias magnetic field to the magnetic material 13 are arranged.

In regard to the coil board 43, the inner end terminals of the two planar coil patterns 42a and 42b are connected to each other. Throughholes 44a and 44b are formed in the center portions of the respective two planar coil patterns 42a and 42b, and a connection conductor pattern 45 (indicated by a dashed line) that is formed on the principal surface opposite from the surface on which the two planar coil patterns 42a and 42b of the coil board 43 are formed and connects the throughholes 44a and 44b. The outer end terminals of the two planar coil patterns 42a and 42b are connected to the current supply terminals 25 and 26, respectively, by way of the connection patterns 23 and 24. As shown in Fig. 11, the coil board 43 abuts against the support board 12. Two planar coil patterns 42a and 42b are facing the other principal surface of the support board 12 that supports the magnetic material 13 on its one principal surface.

In the present embodiment, the planar coil patterns 42a and 42b are connected in series to each other with different polarities across the current supply terminals 25 and 26. It is to be noted in the present invention that the "coil polarity" means the polarity of a magnetic field formed when a DC current flows through the coil, and the "series connection with different polarities" of coils means that a plurality of coils are connected in series to each other, such as the polarities of the magnetic poles of the coils arranged opposite to each other. The distribution of the magnetic field of the composite coil can be appropriately adjusted by changing the specifications and combinations of the coil element. With this arrangement, in the present embodiment, the distribution of the bias magnetic field Hb applied to the magnetic material 13 can be easily controlled by controlling the currents flowing through the two planar coil patterns 42a and 42b. Further, if a number of coil boards 43 of different specifications and combinations of the planar coil patterns 42a and 42b are prepared, then the range of adjustment of the bias magnetic field Hb is remarkably expanded by replacing the coil board 43. According to the present embodiment, a bias magnetic field Hb having magnitude of 0.05 to 10 Oersteds can be easily applied to the magnetic material 13 placed in a position 0.1 to 10 mm apart from the planar coil patterns 42a and 42b. Whereas, because such a bias magnetic field generating means does not have the structure in which a coil is wound around the magnetic material 13, it has a simple structure so that it can be easily manufactured.

### (Third Embodiment)

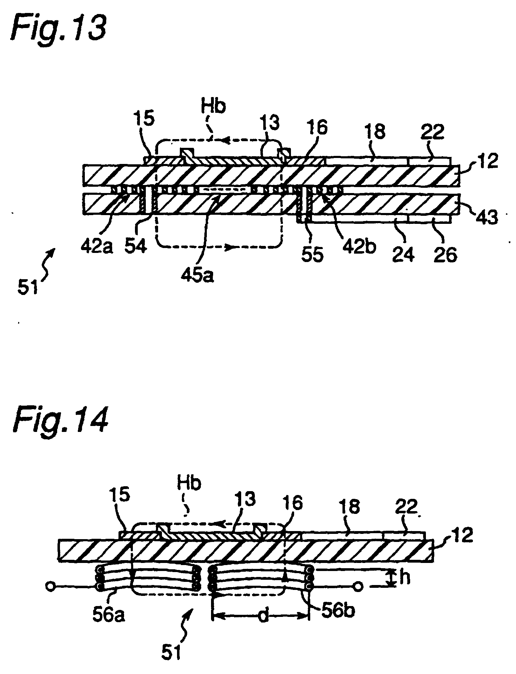

Magneto-impedance effect device 51 according to a third embodiment of the present invention will be described next. In the magneto-impedance effect device 51, a magnetic material is arranged on the upper surface of the support board as shown in Fig. 4 similar to the first embodiment, whereas the lower surface of the support board 12 and the coil board 43 have the structures shown in Fig. 12 and Fig. 13. According to this magneto-impedance effect device 51, two planar coil patterns 42a and 42b are connected to each other by way of a connection conductor pattern 45a. The conductor pattern 4 is composed of a plurality of belt-shaped conductor patterns 33, ..., 33 that have a specified width and a regular interval, and two connection electrodes 52 and 53. Each of the belt-shaped conductor patterns 33, ..., 33 has its dimension X in a direction in which the current flows, the dimension X being larger than the dimension W (see Figs. 4 and 12) of the magnetic material 13.

Connection electrode 52 is connected to the outer end terminal of the planar coil pattern 42a, and the other connection electrode 53 is connected to the outer end terminal of the planar coil pattern 42b. Then, the inner end terminal of the planar coil pattern 42a is connected to the current supply terminal 25 by way of a throughhole 54 and a connection pattern 23. The inner end terminal of the other planar coil pattern 42b is connected to the current supply terminal 26 by way of a throughhole 55 and a connection pattern 24.

According to the present embodiment, equal currents flow through the belt-shaped conductor patterns 33, ..., 33. The magnetic fields formed by the belt-shaped conductor patterns 33 become uniform in the whole region of the connection conductor pattern 45a. Therefore, the bias magnetic field Hb also becomes uniform between the planar coil patterns 42a and 42b. Therefore, a uniform bias magnetic field Hb can be applied to each portion of the magnetic material 13 even in a case where the length of the magnetic material 13 is long and the areas of the planar coil patterns 42a and 42b are limited because of a restriction in terms of the exterior shape of the magneto-impedance effect device 51.

In the above-mentioned first to third embodiments, the magnetic material is arranged on the one principal surface of the support board made of an electrically insulating material, and the bias magnetic field generating means is arranged on the other principal surface. By contrast, an arrangement in which the magnetic material and the bias magnetic field generating means are arranged on one identical principal surface of the support board is also appropriate as magneto-impedance effect device of the present invention. This point will be described below by taking a planar coil similar to that shown in Figs. 10 and 11 as an example. First, spiral type planar coils 42a and 42b are formed on the one principal surface of the electrically insulating support board 43, and an electrically insulating resin or the like is coated on them to form an insulating layer. On the other hand, on the one principal surface of the support board 12 are formed the magnetic material 13 that shows magneto-impedance effect and electrode terminals 15, 16, 17, 18, 21 and 22 for detecting its the electric signal. Then, the magnetic material 13 and the planar coils 42a and 42b are arranged opposite from each other with interposition of the insulating layer. With this arrangement, the magnetic material and the bias magnetic field generating means are kept in an electrically insulated state. It is to be noted that the portions of the current supply terminals 25 and 26 connected to the planar coil 42 must be constructed so as not to receive thereon the insulating layer, and therefore, the insulating layer must be formed only in the required region. Such a patterning can be easily obtained by means of a photosensitive resist that is generally used as a permanent protection mask for a printed circuit board. Furthermore, by forming a multi-layer structure by such a patterning technique, the planar coil and the magnetic material can also be arranged on an identical principal surface of the support board.

### (Fourth Embodiment)

Fig. 14 shows magneto-impedance effect device 51 according to a fourth embodiment of the present invention. This magneto-impedance effect device 51 has a construction in which two solenoid coils 56a and 56b are arranged on the other principal surface of the support board 12 that supports the magnetic material 13 on its one principal surface in a manner that the coil surfaces on the one end side thereof are opposite from the magnetic material 13 and the centers of the coil planes are arranged along the magnetic material 13 in place of the coil board 43 on which the two planar coil patterns 42a and 42b of the magneto-impedance effect device 31 described with reference to Figs. 10 and 11 are formed. The solenoid coils 56a and 56b are connected inversely serially to each other so that the directions of currents flowing through them become opposite to each other. The above two solenoid coils 56a and 56b can be regarded as substantial planar coils when the coil length h is short. A coil having a ratio d/h of the coil length h to the coil outer diameter d (the maximum dimension of the coil sectional surface) equal to or larger than 3 can be used as a substantial planar coil of the present invention.

In each of the first to fourth embodiments described before, the magnetic material is arranged on the one principal surface of the support board made of an electrically insulating material, and the bias magnetic field generating means is arranged on the other principal surface. By contrast, an arrangement in which the magnetic material and the bias magnetic field generating means are arranged on an identical principal surface of the support board is also appropriate for the magneto-impedance effect device of the present invention. For example, a case where a bias magnetic field generating means similar to that of the second embodiment is employed is taken as an example. A bias magnetic field generating means 14 is formed on one principal surface of the electrically insulating support board 12, an electrically insulating resin or the like is coated on it for the formation of an insulating layer and a magnetic material 13 that shows magneto-impedance effect is further arranged on it. With this arrangement, the magnetic material and the bias magnetic field generating means are kept in an electrically insulated state. The portions of the current supply terminals 25 and 26 connected to the bias magnetic field generating means must be constructed so as not to receive thereon the insulating layer, and therefore, the insulating layer must be formed only in the required region. Such patterning can be easily obtained by means of a photosensitive resist used generally as a permanent protection mask for a printed circuit board.

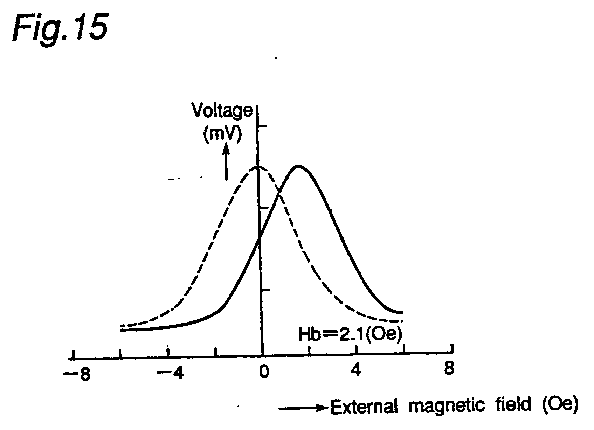

Also, in the fourth embodiment, the two solenoid coils 56a and 56b are connected inversely serially to each other. Therefore, by controlling the currents flowing through these two solenoid coils 56a and 56b, the planar bias magnetic field Hb as indicated by a dashed line in Fig. 14 can be obtained, and the distribution of the bias magnetic field can be easily controlled. For example, in magneto-impedance effect device 51, the bias magnetic field generating means is provided by solenoid coils 56a and 56b that are constructed having aperture diameter of 10 mm, the number of turns of 10 and wire diameter of 0.1 mm and are inversely serially connected to each other with interposition of a center-to-center distance of 12 mm. Then, bias magnetic field Hb with magnitude of 0.05 to 10 Oersteds can be easily generated for the magnetic material 13 arranged in a position 0.1 to 10 mm apart from the one end of each of the solenoid coils 56a and 56b. Then, a magneto-impedance effect device can detect the magnitude and direction (polarity) of the external magnetic field having a characteristic as indicated by a solid line in Fig. 15. In the present embodiment, coils of various shapes can be employed in place of the two solenoid coils 56a and 56b. For example, a coil obtained by winding a conductor wire like a shape of character of "8" or the like can be employed.

Second to Fifth Examples of the magneto-impedance effect device described above will be described below.

### (Second Example)

Magneto-impedance effect device 51 according to the second embodiment of the present invention was formed as follows. A means for applying the bias magnetic field Hb was placed on the coil board 43 as described with reference to Fig. 10. The planar coil patterns 42a and 42b formed on the coil board 43 were each formed by etching a copper foil adhered to the coil board 43 into a rectangular spiral shape of line width of 0.2 mm and six turns. The planar coil patterns 42a and 42b were inversely serially connected to each other by way of throughholes 44a and 44b and the connection conductor pattern 45 so that the magnetic fields generated by them come to have reverse polarities. Then, the coil board 43 was arranged in an abutment manner on the other principal surface of the support board 12, on which the magnetic material 13 is formed, opposite from the principal surface. The magnetic material 13 was located on a line segment which connected the centers of the planar coil patterns 42a and 42b and the direction of the bias magnetic field Hb and the lengthwise direction of the magnetic material 13 coincided with each other.

Then, the produced magneto-impedance effect device 51 was subjected to the measurement of the magnetic field detection characteristic with the circuit shown in Fig. 8 according to a method similar to that of the First Example. Fig. 15 shows results of the measurement. In Fig. 15, a dashed line represents the output characteristic when a current is not flown through the planar coil patterns 42a and 42b, the characteristic being symmetrical about the vertical axis. When a current is flown through the planar coil patterns 42a and 42b, the output characteristic is asymmetrical about the vertical axis as indicated by a solid line. That is, when current of 0.3 ampere flows through the planar coil patterns 42a and 42b, an operating point of the magneto-impedance effect device 11 is shifted by 2.10 Oersteds in the direction of the horizontal axis. With this arrangement, it was confirmed that the magnitude and polarity (direction) of the magnetic field could be detected by the magneto-impedance effect device 11.

### (Third Example)

Next, magneto-impedance effect device according to the third embodiment of the present invention was formed as follows. As a means for applying the bias magnetic field Hb, a coil board 43 was produced having the planar coil patterns 42a and 42b and the connection conductor pattern 45a described with reference to Fig. 12. The planar coil patterns 42a and 42b and the connection conductor pattern 45 formed on the coil board 43 were each formed by etching a 0.03 mm thick copper foil adhered to the coil board 43. The planar coil patterns 42a and 42b and the connection conductor pattern 45 each had line width of 0.2 mm, the planar coil patterns 42a and 42b had spiral shape of three turns and the number of the belt-shaped conductor patterns 33 is nine. Then, the coil board 43 was arranged in an abutment manner on the other principal surface of the Support board 12, on which the magnetic material 13 was formed, opposite from the principal surface. The magnetic material 13 was located on a line segment which connected the centers of the planar coil patterns 42a and 42b and the direction of the bias magnetic field Hb and the lengthwise direction of the magnetic material 13 coincided with each other. The magnetic material 13, the planar coil patterns 42a and 42b and the connection conductor pattern were located at intervals of 0.8 mm.

Next, a current of 1.2 amperes is flows through the planar coil patterns 42a and 42b and the connection conductor pattern, and the characteristic of the produced magneto-impedance effect device 51 was measured according to a method similar to that of the First Example. As a result, it was discovered that bias magnetic field Hb of 2.0 Oersteds was applied to the magnetic material 13. Then, it was confirmed that the magnitude and polarity (direction) of the magnetic field could be detected by the magneto-impedance effect device 31, similarly to the First Example.

### (Fourth Example)

Magneto-impedance effect device according to the fourth embodiment of the present invention was formed as follows. As a means for applying the bias magnetic field Hb, the solenoid coils 56a and 56b shown in Fig. 14 were produced. These solenoid coils 56a and 56b were formed of a clad conductor wire of 0.2 mm, and the coils were wound by five turns so that outer aperture diameter d of 5 mm and length h of 1.0 mm were achieved for the provision of aspect ratio of 5 (ratio d/h of the length h to coil outer diameter d). Then, the two solenoid coils 56a and 56b were connected to each other so that the magnetic fields generated by them have reverse polarities when a current is flown through them and one end side of the coils were opposite from the magnetic material 13 with interposition of the support board 12, as shown in Fig. 14.

Then, the characteristic of the produced magneto-impedance effect device 51 was measured by a method similar to that of the First Example. As the result of measurement, it was confirmed that a bias magnetic field Hb of 2.1 Oersteds was applied to the magnetic material 13 when a current of 0.3 ampere was made to flow through the solenoid coils 56a and 56b.

### (Fifth Embodiment)

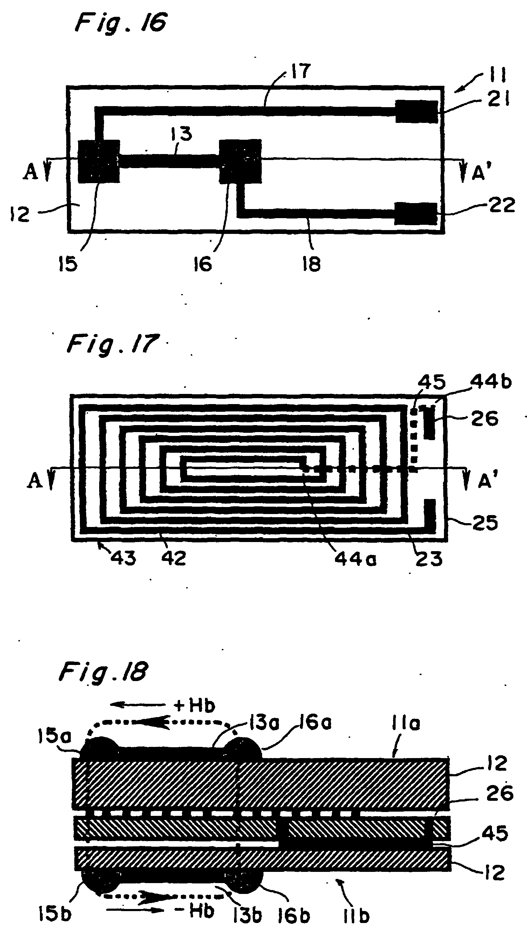

Figs. 16, 17 and 18 show a magneto-impedance effect device according to a fifth embodiment of the present invention. The magneto-impedance effect device has a construction in which a magnetic material 13 having magneto-impedance effect is arranged on one principal surface of a rectangular support board 12 made of an electrically insulating material such as glass or glass epoxy resin, as shown in Fig. 16. The magnetic material 13 has its both ends electrically connected to the connection electrodes 15 and 16 formed on the above-mentioned principal surface of the support board 12. These connection electrodes 15 and 16 are led to terminal electrodes 21 and 22 formed in the vicinity of the edge of the above-mentioned principal surface of the support board 12 by way of connection patterns 17 and 18. An AC current is applied across the terminal electrodes 21 and 22.

As shown in Fig. 17, a spiral planar coil pattern (spiral coil) 42 for applying bias magnetic field to the magnetic material 13 is formed on a coil board 43. Terminal electrodes 25 and 26 are formed in the vicinity of the edge of one principal surface of the coil board 43. The outer peripheral line of the planar coil 42 is connected to the terminal electrode 25, while the inner peripheral line is connected via a throughhole 44a to the connection conductor pattern 45 of the other principal surface and further connected via the throughhole 44b to the terminal electrode 26. A current for generating a bias magnetic field is applied across the terminal electrodes 25 and 26.

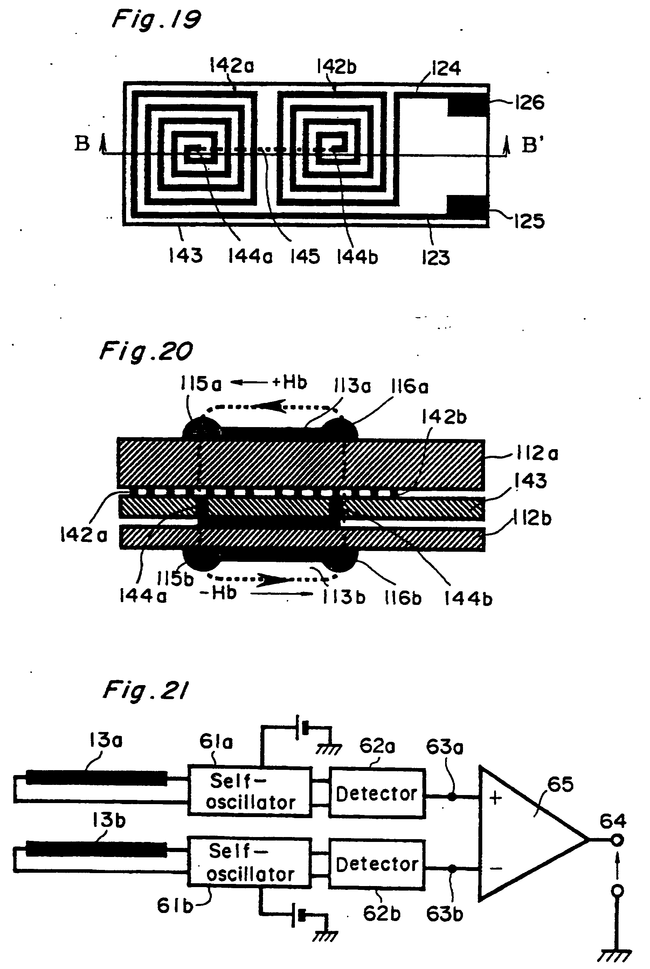

As shown in Fig. 18, the composite magneto-impedance effect device 11 comprises two layered support boards 12 of the magneto-impedance effect devices 11 and one coil board 43. (The two support boards 12 and the components thereon are distinguished by the suffixes "a" and "b".) The coil board 43 for applying the bias magnetic field to the magnetic material is arranged between two support boards 12a and 12b provided with magnetic materials 13a and 13b. The coil board 43 is arranged on the principal surface side provided with no magnetic material of the support board 12a, 12b. A distance between both end electrode portions of the magnetic material 13 is preferably shorter than at least a distance (radius) between the center and the periphery of the planar coil pattern 42. Further, the two magnetic materials 13a and 13b are preferably positioned at a distance equally apart from the coil principal surface. In the example shown in Fig. 16, both end electrode portions 15 and 16 are positioned between the center and the periphery of the planar coil pattern 42. By combining the three boards, the magnetic materials 13 can be simply and securely supported, and the distances between the magnetic materials 13a and 13b and the planar coil pattern 42 are correctly defined. In the present embodiment, one end portion of the magnetic materials 13a and 13b was arranged at the center of the planar coil pattern 42, and connection electrodes 16a and 16b were formed on them. The other end portion was arranged in the outermost peripheral portion of the planar coil pattern 42, and connection electrodes 15a and 15b were formed on them.

If the magnetic materials 13a and 13b are located in positions symmetrical about the planar coil pattern 42, a similar effect can be obtained wherever the connection electrodes 16a and 16b are located within a region from the center to the periphery of the planar coil pattern. If amorphous magnetic wires 13 are electrically connected by way of the connection electrodes 15 and 16 and located within a distance between the center of the planar coil pattern and the peripheral portion of the coil, then a similar effect can be obtained without any limitation on the length of the magnetic wires. However, the magnetic wires should preferably have an equal length in order to prevent the occurrence of a difference in detection sensitivity between the two magnetic wires.

Thus, this arrangement causes excellent reproducibility in the characteristic and eases to cope with the various specifications of magnetic sensors to be used for various applications.

In the present embodiment, the magnetic field is generated by DC current through the planar coil pattern 42. The distribution of the bias magnetic field Hb applied to the magnetic materials 13 can be easily controlled through appropriate adjustment of the coil pattern. If a laminating technique of the printed circuit board is used for the support boards 12a and 12b and the coil board 43, an integrated wiring pattern can be formed. According to the present embodiment, a bias magnetic field Hb of magnitude of 0.05 to 10 Oersteds can be applied to the magnetic materials 13 in the opposite direction when the magnetic materials are arranged in a position 0.1 to 10 mm apart from the planar coil pattern 42. Furthermore, the present embodiment, which does not have the structure in which a coil is wound around the magnetic material 13, has a simple structure and can be easily manufactured.

### (Sixth Embodiment)

Figs. 19 and 20 show a magneto-impedance effect device according to a sixth embodiment of the present invention. This composite magneto-impedance effect device 11 has a construction in connection with a coil board 143 in which two planar coils 142a and 142b are connected in series to each other on an identical principal surface in place of the one planar coil pattern 42 of the magneto-impedance effect device 11 of the fifth embodiment described with reference to Figs. 16 and 17. The planar coils 142a and 142b are connected to each other via throughholes 144a and 144b formed in the respective center portions by way of a connection conductor pattern 145 formed on the principal surface that is opposite from the principal surface on which the two planar coil patterns 142a and 142b of the coil board 143 are formed, so that the inner end terminals of the planar coil patterns 142a and 142b are connected to each other. The outer end terminals of the two planar coil patterns 142a and 142b are connected to current supply terminals 125 and 126, respectively, by way of connection patterns 123 and 124.

As shown in Fig. 20, the coil board 143 is made to abut against a support board 112a with its two planar coil patterns 142a and 142b facing the other principal surface of the support board 112a that supports the magnetic material 13 on its one principal surface. Then, the other support board 112b is made to abut against the coil board 143 with its other principal surface that is not supporting the magnetic material 113b facing the principal surface on which the connection conductor pattern 145 of the coil board 143 exists.

According to the present embodiment, the spiral type planar coil patterns 142a and 142b are formed into an identical planer shape and are arranged on the coil board 143. The magnetic materials 113a and 113b are located in the positions symmetrical about the surface on which the spiral type planar coil patterns 142 is arranged. The magnetic materials 113a and 113b have an equal length and, one end portion of which is located at the center of the spiral type planar coil pattern 142a, and the other end portion of which is located at the center of the spiral type planar coil pattern 142b.

In the present embodiment, the planar coil patterns 142a and 142b are connected in series to each other with different polarities between the current supply terminals 125 and 126. As described before, the "polarity" of the coil means the polarity of the magnetic field formed when DC current flows through the coil, and the "coil is connected in series with different polarities" means that a plurality of coils are connected in series to each other with the polarities of the magnetic poles at the mutually connected end terminals of the coils arranged opposite to each other in the present invention. According to this arrangement, the distribution of the bias magnetic field Hb applied to the magnetic material 113 can be easily controlled by controlling the current flowing through the two planar coil patterns 142a and 142b. According to the present embodiment, a bias magnetic field Hb having a magnitude of 0.05 to 10 Oersteds can be easily applied to the magnetic material 113 placed in a position 0.1 to 10 mm apart from the planar coil patterns 142a and 142b. Furthermore, the coil for generating the bias magnetic field, which does not have the structure in which a coil is wound around the magnetic material 113, has a simple structure and can be easily manufactured.

In regard to the magnetic materials 113a and 113b, the length between the electrodes formed into the magnetic material should preferably be shorter than at least length between the centers of the planar coils 142a and 142b, and the two magnetic materials 113a and 113b should preferably be positioned at a distance equally apart from the coil principal surface with interposition of the coils 142a and 142b.

If a condition of the relative positional relationship that the two magnetic materials 113 are located in positions symmetrical about the coil 142 is satisfied, then a similar effect can be obtained wherever the connection electrodes 115 and 116 are located within a straight line which connects the centers of the two spiral type planar coils 142.

Next, Fifth to Sixth Examples of the above-mentioned magneto-impedance effect device will be described.

### (Fifth Example)

The above-mentioned magneto-impedance device 51 according to the fifth embodiment of the present invention was formed. Next, as a means for applying the bias magnetic field Hb, the coil board 43 described with reference to Fig. 17 was produced. The planar coil pattern 42 formed on the coil board 43 was formed by etching a copper foil adhered to the coil board 43 into a rectangular spiral form of line width of 0.2 mm and 12 turns. The planar coil pattern 42 was connected by way of the throughholes 44a and 44b and the connection conductor pattern 45. Then, the magnetic materials 13a and 13b were arranged symmetrical about the planar coil pattern 42 of the coil board 43. In this case, the coil board 43 abutted against the other principal surface opposite from the principal surface on which the magnetic materials 13a and 13b of the support boards 12a and 12b were arranged. Thus, the bias direction coincided with the lengthwise direction of the magnetic materials 13a and 13b when a current flowed through the planar coil pattern 42 and bias magnetic fields +Hb and -Hb were generated. It is to be noted that the support board 12a abuts against the principal surface that has the planar coil pattern of the coil board 43. Therefore, the support board 12a has thickness greater than that of the support board 13b by the thickness of the coil board 43 so that the magnetic materials 13a and 13b are located at equal distances from the planar coil pattern 42. In this case, the thickness of the coil board 43 was 0.2 mm, and therefore, the thickness of the support board 12b was set to 0.4 mm.

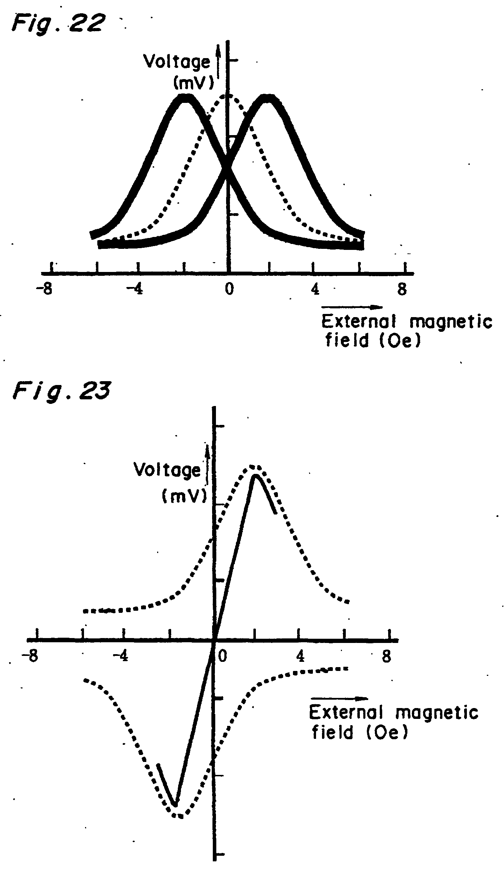

Then, the magnetic field detection characteristic of the magneto-impedance effect device 11 was measured with a circuit as shown in Fig. 21. In Fig. 21, two self-oscillation circuits 61a and 61b are operated on the respective DC power sources, and high-frequency current of 20 MHz flows through the magnetic materials 13a and 13b. The detection circuits 62a and 62b detect output signals from the self-oscillation circuits 61a and 61b. A differential amplifier 65 outputs a change in impedance of the magnetic materials 13a and 13b as a change in electric signal from an output terminal 64.

Next, the magneto-impedance effect device 11 whose circuit was connected as described above was subjected to the measurement of the magnetic field detection characteristic according to a method similar to that of the First Example. Fig. 22 shows the results of measurement at output points 63a and 63b subsequent to the detection circuits in the circuit of Fig. 21. In Fig. 22, a dashed line represents the output characteristic when a current is not flown through the planar coil pattern 42, the characteristic being symmetrical about the vertical axis. When a current is flown through the planar coil pattern 42, the output characteristics of the magneto-impedance effect devices 11a and 11b are asymmetrical about the vertical axis as indicated by the solid lines in Fig. 22. That is, when a current of 0.3 ampere is flows through the planar coil pattern 42, there can be obtained a characteristic such that the operating point of the magneto-impedance effect device 11a is shifted by +2.1 Oersteds in the positive direction of the horizontal axis. There can be obtained a characteristic such that the operating point of the magneto-impedance effect device 11b is shifted by -2.1 Oersteds in the negative direction of the horizontal axis. With this arrangement, it was confirmed that both magnitude and polarity (direction) of the magnetic field could be detected by using the magneto-impedance effect devices 11a and 11b.

Fig. 23 shows the external magnetic field detection characteristic obtained at the output terminal 64 of the circuit of Fig. 21. The characteristic electric signals subsequent to the detection circuits 63a and 63b are converted by the differential amplifier 65. Therefore, the output comes to have a linear characteristic that passes through the origin with respect to the external magnetic field within ±2.1 Oersteds, and this proves that the signal-to-noise ratio is improved.

### (Sixth Example)

The magneto-impedance effect device 51 according to the sixth embodiment of the present invention was formed as follows. As a means for applying the bias magnetic field, the coil board 143 having the planar coil patterns 142a and 142b described with reference to Fig. 19 was produced. The planar coil patterns 142a and 142b formed on the coil board 143 were formed by etching a 0.03 mm thick copper foil adhered to the coil board 143. Each portion of the planar coil patterns 142a and 142b had line width of 0.2 mm, and the number of turns of the planar coil patterns 142a and 142b were each six turns. Then, planar coil patterns 142a and 142b were inversely serially connected to each other by way of throughholes 144a and 144b and a connection conductor pattern 145 so that the magnetic fields generated by them have reverse polarities. Then, the coil board 143 was arranged in an abutment manner on the other principal surfaces of the support board 112 oppositely from the principal surfaces on which the magnetic materials 113a and 113b were arranged. In this arrangement, the magnetic materials 113a and 113b were located in a position with interposition of the coil board 143, located on a line segment which connected the centers of the two planar coil patterns 142a and 142b. Thus, the direction of the bias magnetic field Hb and the lengthwise direction of the magnetic materials 113 coincided with each other.

Next, the characteristic of the produced magneto-impedance effect device 111 was measured by flowing DC current of 0.2 ampere through the planar coil patterns 142a and 142b according to a method similar to that of the Fourth Example. As a result, it was discovered that a bias magnetic field Hb of a magnitude of 1.4 Oersteds was applied to the magnetic materials 113a and 113b. Then, it was confirmed that the magnitude and polarity (direction) of the magnetic field could be detected by the above-mentioned magneto-impedance effect device 111 similar to the Fifth Example and that the output voltage relative to the external magnetic field had a high signal-to-noise ratio as well as a linear characteristic which passes through the origin.

Although the present invention has been described in detail by way of the embodiments thereof, the embodiments have been described merely as examples, and the present invention is not limited to the above-mentioned embodiments. The present invention includes modifications that can be made by those skilled in the art within the scope of the appended claims.

## Claims

1. Magneto-impedance effect device comprising:
at least one magnetic material having magneto-impedance effect; and
a bias magnetic field generating means, comprised of a conductor pattern positioned within a plane, for applying a magnetic field generated by a current flowing through the conductor pattern as a bias magnetic field to the magnetic material.

2. Magneto-impedance effect device as claimed in claim 1, wherein the conductor pattern is arranged so that the magnetic material generally crosses a direction of the current flowing through the conductor pattern, and the conductor pattern is comprised of a plurality of belt-shaped patterns that have a dimension in the direction in which the current flows, the dimension being greater than a dimension of the magnetic material in a direction perpendicular to the direction in which the magnetic material extends.

3. Magneto-impedance effect device as claimed in claim 1, wherein the bias magnetic field generating means is comprised of a plurality of planar coil elements provided on an identical surface approximately parallel to the magnetic material and a connecting member for connecting these coil elements so that magnetic fields generated by currents flowing through the coil elements are reverse to each other, and a synthetic magnetic field of the magnetic fields generated by the currents flowing through the coil elements is applied as the bias magnetic field to the magnetic material.

4. Magneto-impedance effect device as claimed in claim 3, wherein the planar coil is provided by spiral coils, the connecting member electrically connects end portions of adjacent spiral coils to each other, and the magnetic material is arranged along the connecting member.

5. Magneto-impedance effect device as claimed in claim 4, wherein the magnetic material is arranged on one principal surface of one support board, the planar coil is arranged on a coil board, and the support board is arranged on the coil board with the other principal surface facing the planar coil.

6. Magneto-impedance effect device as claimed in claim 4, wherein the magnetic material and the bias magnetic field generating means are supported on one principal surface of a support board while being electrically insulated from each other.

7. Magneto-impedance effect device as claimed in claim 4, 5 or 6, wherein the connecting member has a conductor pattern whose dimension in the direction in which the current flows is greater than a dimension of the magnetic material in a direction perpendicular to the direction in which the magnetic material extends.

8. Magneto-impedance effect device as claimed in claim 4, wherein the bias magnetic field generating means is comprised of flat solenoid coils whose conducting wires are wound in reverse directions to each other, and the flat solenoid coils are connected to each other so that the directions of magnetic fields generated by the coils are reverse to each other.

9. Magneto-impedance effect device as claimed in claim 3, wherein two magnetic materials are provided, and the two magnetic materials are arranged in positions with interposition of the planar coil element of the bias magnetic field generating means.

10. Magneto-impedance effect device as claimed in claim 9, wherein the planar coil element is comprised of at least two spiral coils, the connecting member electrically connects end portions of the at least two spiral coils so that the magnetic fields generated by the currents flowing through the spiral coils are reverse to each other, and the magnetic material is arranged along the connecting member.
